(19)

Europäisches
Patentamt
European
Patent Office
Office européen
des brevets

(11) **EP 3 296 692 A1**

(12) **EUROPEAN PATENT APPLICATION**
published in accordance with Art. 153(4) EPC

(43) Date of publication:
**21.03.2018 Bulletin 2018/12**

(51) Int Cl.:
**G01C 19/5712** *(2012.01)*  **G01C 19/574** *(2012.01)*
**B81B 7/02** *(2006.01)*

(21) Application number: **16792952.0**

(22) Date of filing: **10.05.2016**

(86) International application number:
**PCT/KR2016/004861**

(87) International publication number:
**WO 2016/182306 (17.11.2016 Gazette 2016/46)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **12.05.2015  KR 20150066097**

(71) Applicant: **Shin Sung C&T Co., Ltd.**
**Geumcheon-gu, Seoul 08501 (KR)**

(72) Inventors:
• **SONG, Ci Moo**
  **Yongin-si**
  **Gyeonggi-do 16809 (KR)**

• **YOUN, Keun Jung**
  **Incheon 22572 (KR)**
• **KANG, Jeong Sik**
  **Seoul 05245 (KR)**
• **KIM, Yong Kook**
  **Seoul 04407 (KR)**
• **HAN, Seung Ho**
  **Asan-si**
  **Chungcheongnam-do 31471 (KR)**
• **SONG, Hyun Ju**
  **Seoul 03747 (KR)**

(74) Representative: **Gulde & Partner**
**Patent- und Rechtsanwaltskanzlei mbB**
**Wallstraße 58/59**
**10179 Berlin (DE)**

(54) **SYMMETRICAL Z-AXIS MEMS GYROSCOPE**

(57)    A novel symmetrical Z-axis MEMS gyro-scope is provided. The MEMS gyroscope comprises: a sensor frame arranged parallel to a bottom wafer substrate; a sensor mass body moving relative to the sensor frame and excited at one degree of freedom in an excitation mode; and at least one sensing electrode for sensing the displacement of the sensor mass body at one degree of freedom in a sensing mode by Coriolis force when an external angular velocity is inputted into the sensor mass body, wherein the sensor mass body comprises two mass units, the two mass units are arranged in an axisymmetric form to each other, and the antiphase movements of the two mass units are maintained by an antiphase link device directly or indirectly connected between the two mass units.

[FIG. 1]

EP 3 296 692 A1

**Description**

[TECHNICAL FIELD]

The present invention relates to a MEMS gyroscope. More particularly, the present invention relates to a symmetrical z-axis MEMS gyroscope utilizing the principle of detecting the movement of a sensor mass body, in accordance with a Coriolis force generated by exciting the sensor mass body rotating in a first direction in a second direction.

[BACKGROUND ART]

MEMS (Micro Electro Mechanical excitation systems) is a technique for achieving mechanical and electrical components using a semiconductor process, and a MEMS gyroscope which measures angular velocity is a representative example of utilizing MEMS technique. The gyroscope measures an angular velocity by measuring a Coriolis force generated when a rotational angular velocity is applied to an object moving at a predetermined speed. At this time, the Coriolis force is proportional to the cross product of the moving speed and the rotational angular speed due to the external force.

Further, in order to detect the generated Coriolis force, the gyroscope is provided with a mass which vibrates inside. Normally, a direction in which the mass in the gyroscope is driven is referred to as an excitation direction, a direction in which the rotational angular velocity is input to the gyroscope is referred to as an input direction, and a direction of detecting the Coriolis force generated in the mass is referred to as a sensing direction.

The excitation direction, the input direction, and the sensing direction are set as mutually orthogonal directions on the space. Normally, in a gyroscope utilizing the MEMS technique, coordinate axes are sets in three directions including two directions (a horizontal direction or x, y-directions) parallel to a plane formed by a bottom wafer substrate and perpendicular to each other, and one direction (a vertical direction or a z-direction) perpendicular to the plate surface of the substrate.

Therefore, the gyroscope is divided into an x-axis (or y-axis) gyroscope and a z-axis gyroscope. The x-axis gyroscope is a gyroscope in which the input direction is the horizontal direction, and the y-axis gyroscope is based on the vertical axis on the plane but is substantially the same as the x-axis gyroscope in the principle aspect. Thus, the x-axis and y-axis gyroscopes are collectively referred to as x-y axis gyroscopes. Meanwhile, in order to measure the angular velocity applied in the vertical direction using the z-type gyroscope, excitation needs to be performed in one axial direction on the plane, and the sensing needs to be performed in the direction perpendicular to the one axis on the plane. Accordingly, all the excitation electrodes and the sensing electrodes are located on the same bottom wafer.

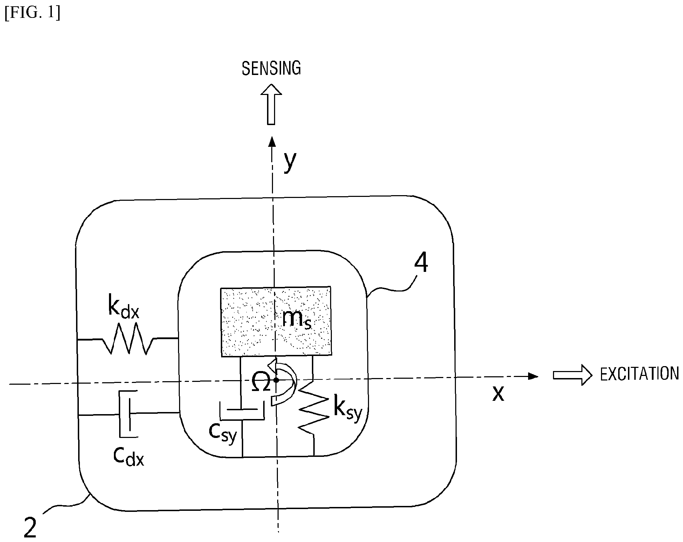

FIG. 1 is a schematic diagram illustrating a z-axis MEMS gyroscope having a conventional one degree of freedom (DOF) horizontal excitation and 1e degree of freedom horizontal sensing function. Here, it is possible to understand that a frame 2 and a sensor 4 are provided inside the gyro wafer, the sensor 4 is connected to the frame 2 by a spring $k_{dx}$ and an attenuator $c_{dx}$, and the sensor mass body ms is connected to the sensor 4 by a spring $k_{sy}$ and an attenuator $c_{sy}$.

A vibrating sensor mass body ms is located inside the MEMS-based gyroscope. When an angular velocity is applied around the z-axis perpendicular to the excitation direction x from the outside, the Coriolis force ($Fc = 2\,m\Omega \times \omega A\sin \omega t$) acts on the sensor mass body in a third direction y perpendicular to the plane formed by the excitation direction x and its vertical axis z, and the magnitude of the displacement of the sensor mass body ms which varies with the Coriolis force is detected. Here, ms is a mass of the sensor mass body, $\Omega$ is the external angular velocity, $\omega$ ($= 2\pi f$) is the excitation frequency of the sensor mass body, A is the driving amplitude of the sensor, and t is time. Since the performance sensitivity of the MEMS-based gyroscope is defined by Coriolis force ($Fc/\Omega = 2\pi m f A$) in comparison with the unit angular velocity, it is required to increase the mass m of the sensor at the design stage or increase the excitation frequency f of the sensor or increase the driving amplitude A.

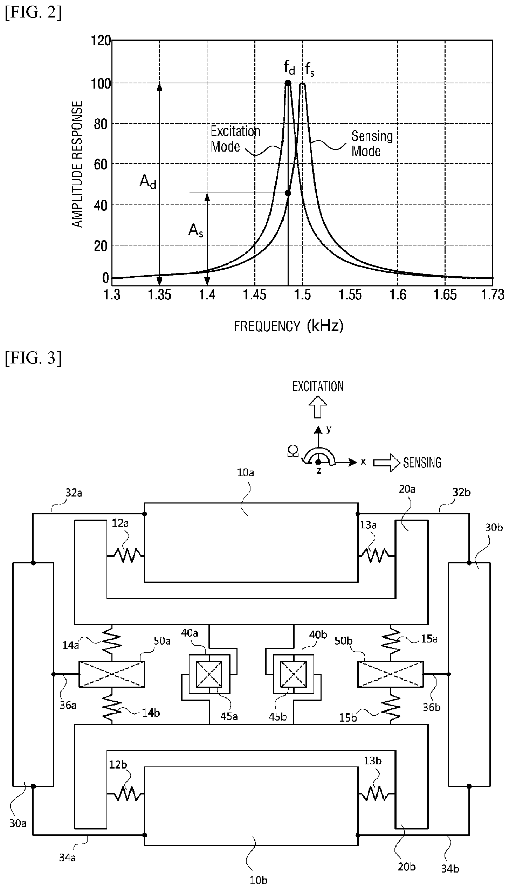

In the conventional z-axis gyroscope as illustrated in FIG. 1, since the maximum driving amplitude A of the sensor is displayed at the excitation resonance frequency of the excitation frequency response curve as illustrated in FIG. 2, it is necessary to match the excitation frequency f of the sensor with the excitation resonance frequency fd of the sensor. Also, the driving amplitude As of the sensor is determined by how closely the excitation resonance frequency fd to the sensor is brought closer to the sensing resonance frequency fs of the sensor, that is, the degree of frequency matching. Also, the driving amplitude Ad of the sensor increases in proportion to the maximum amplitude ratio Qd (Quality factor) of the static deformation of the mechanical excitation system, and the sensor driving amplitude As also increases in proportion to the maximum amplitude ratio Qs (Quality factor) of the static deformation of the mechanical sensing system. Therefore, in order to simultaneously increase such Qd or Qs, it is common to operate after sealed packaging in vacuum of a mechanical sensing / sensing system such as a frame and a sensor.

On the other hand, the magnitude of the movement of the sensor mass body caused by the Coriolis force is calculated by measuring the variation of the electrostatic capacitance C between the sensor mass body and the fixed detecting electrode. It is not possible to avoid a parasitic capacitance generated by an excitation voltage relatively larger than the sensing signal from being included in the sensing signal which is output from the fixed sensing electrode, as the noise. Therefore, as in a z-axis gyroscope of FIG. 1, the overall sensitivity in the gyroscope sensor in which the excitation and sensing system has degree of freedom of 1 is defined by, as illustrated in FIG. 2, the degree of matching (difference between fs and fd) between the sensing resonance frequency fs of the sensor mass body and the excitation resonance frequency fd, second, the maximum amplitude ratio Q of each of the excitation sensing systems, and a ratio between the sensor output signal and the noise due to the parasitic capacitance, that is, the signal-to-noise ratio.

In conclusion, as the excitation resonance frequency fd of the sensor closely matches the sensing resonance frequency fs, the overall sensitivity of the angular velocity can be maximized. However, an attempt to obtain the maximum sensing amplitude As by bringing fd close to fs causes a result of an increase in deviation of the detected amplitudes As of individual chips in the wafer in the manufacturing process, due to a problem in which sensing resonance frequency fs and the excitation resonance frequency fd sensitively change because of a micro-fabrication process error of the MEMS-based gyroscope structure, which ultimately leads to a cause of significant reduction in production yield.

Meanwhile, since the ultra-small precision instruments such as MEMS gyroscopes are sensitive to external noise or manufacturing process errors, the toughness or stability of the system is a very important consideration factor. However, it is difficult to have these robust and stable structures when using a single mass as illustrated in FIG. 1 in the z-axis gyroscope. As a solution to these problems, a z-axis MEMS gyroscope in which the same two masses are arranged in a line symmetrical structure with each other in the y-axis direction (sensing direction) (reverse direction arrangement), and the motion in the sensing mode also has antiphase (antiphase vibration) is known. If perfect antiphase of the above two masses are guaranteed in the sensing mode, since errors of the manufacturing process or errors due to external noise are cancelled out due to their symmetry, the accuracy of MEMS gyroscope will be improved.

However, as mentioned above, even if the MEMS gyroscope is designed to have a perfect antiphase structure and antiphase oscillation, in fact, excitation of the excitation electrode does not have perfect antiphase, or even if excitation is performed to the perfect antiphase, it is not easy to secure perfect antiphase motion in the sensing mode, due to errors in various manufacturing processes, external noise, or the like.

Therefore, in a symmetric z-axis MEMS gyroscope with two masses, it is necessary to devise a structure that is easy to manufacture and can also ensure perfect antiphase in the excitation mode or the sensing mode.

[DISCLOSURE OF INVENTION]

[Technical Problems]

An aspect of the present invention provides a symmetric z-axis MEMS gyroscope capable of ensuring perfect antiphase in the excitation mode or sensing mode.

Another aspect of the present invention provides a symmetric z-axis MEMS gyroscope that is easy to manufacture and is resistant to external noises.

The aspects of the present invention are not limited to those mentioned above and another aspect which is not mentioned can be clearly understood by those skilled in the art from the description below.

[Technical Solutions]

According to an aspect of the present invention, there is provided a z-axis MEMS gyroscope including: a sensor frame disposed parallel to a bottom wafer substrate; a sensor mass body which relatively moves to the sensor frame, and is excited at one degree of freedom in an excitation mode; and at least one sensing electrode which senses displacement of the sensor mass body at the one degree of freedom in a sensing mode by Coriolis force, when an external angular velocity is input to the sensor mass body, wherein the sensor mass body includes two mass units, the two mass units are arranged in line symmetry with each other, and the antiphase motion of the two mass units is maintained by an antiphase link mechanism directly or indirectly connected between the two mass units.

[Advantageous Effects of Invention]

According to the symmetrical z-axis MEMS gyroscope according to the present invention, since a perfect antiphase is guaranteed in the excitation mode or the sensing mode, it is possible to provide some degree of robust performance against a micro process error or an external noise.

Since the provision of the toughness is provided using a simple MEMS structure that can be manufactured in an integrated gyro wafer processing process, there is an advantage that no special additional process or cost occurs.

[BRIEF DESCRIPTION OF DRAWINGS]

FIG. 1 is a schematic diagram illustrating a z-axis MEMS gyroscope having horizontal excitation of one degree of freedom (DOF) and horizontal sensing function of one degree of freedom.
FIG. 2 is a diagram illustrating a frequency response curve of a z-axis gyroscope of a conventional one degree of freedom horizontal excitation and one degree of freedom horizontal sensing mode.

FIG. 3 is a schematic diagram for explaining a z-axis gyroscope driving principle of a horizontal excitation and horizontal sensing type according to an embodiment of the present invention.

FIG. 4 is a diagram illustrating an antiphase link mechanism according to an embodiment of the present invention.

FIG. 5 is a view illustrating an antiphase link mechanism according to another embodiment of the present invention.

FIG. 6 is a diagram illustrating an antiphase link mechanism according to another embodiment of the present invention.

FIG. 7 is a diagram illustrating a structure of a z-axis gyroscope subjected to horizontal excitation and a horizontal sensing on an x-y plane according to an embodiment of the present invention.

FIG. 8 is a diagram schematically illustrating a cross section taken along the line A-A' of the z-axis MEMS gyroscope of FIG. 7.

FIG. 9 is a plan view schematically illustrating a large number of anchors connected to a bottom wafer, a silicon penetration electrode of the bottom wafer, and a sealing wall with respect to the z-axis gyroscope according to the embodiment of FIG. 7.

FIG. 10 is a diagram schematically illustrating a cross section of the x-y axis gyroscope taken along the line B-B' of FIG. 9.

FIG. 11 is a diagram illustrating the structure of z-axis gyroscope subjected to the horizontal excitation and the horizontal sensing on the x-y plane according to another embodiment of the present invention.

[BEST MODES FOR CARRYING OUT THE INVENTION]

Advantages and features of the present invention and methods of accomplishing them will become apparent with reference to the embodiments described in detail below with reference to the accompanying drawings. It should be understood, however, that the present invention is not limited to the embodiments disclosed below but may be embodied in various different forms, the embodiments are merely provided to make the disclosure of the present invention complete, and to completely inform the invention to a person having ordinary knowledge in the technical field to which the invention belongs, and the present invention is only defined by the scope of the claims. The sane reference numerals refer to the same constituent elements throughout the specification.

Further, the embodiments described herein will be described with reference to a perspective view, a cross-sectional view, a side view, and/or a schematic view, which are ideal illustrations of the present invention. Therefore, the form of the illustration can be modified by manufacturing technique and / or tolerance and the like.

Therefore, the embodiments of the present invention are not limited to the specific forms illustrated, but also include a change in the form generated according to the manufacturing process. Also, in each drawing illustrated in the present invention, each constituent element may be slightly enlarged or reduced in view of the convenience of explanation.

Hereinafter, an embodiment of the present invention will be described in detail with reference to the accompanying drawings.

FIG. 3 is a schematic diagram for explaining a driving principle of a horizontal excitation and horizontal sensing type z-axis gyroscope according to an embodiment of the present invention. Referring to FIG. 3, under the condition that the rotation in the z-axis direction is applied onto the gyro wafer, if the sensor mass bodies 10a and 10b and the sensor frames 20a and 20b are excited in the y-direction, movement in the x-axis direction occurs in the sensor mass bodies 10a and 10b by Coriolis force. Here, the sensor mass bodies 10a and 10b include a first sensor mass body unit 10a and a second sensor mass body unit 10b, and the sensor frames 20a and 20b may be configured to include a first sensor frame unit 20a and a second sensor frame unit 20b. The sensor mass bodies 10a and 10b are connected to the sensor frames 20a and 20b by support springs 12a, 13a, 12b, and 13b arranged in the horizontal direction, respectively. Therefore, the sensor mass bodies 10a and 10b may have a relative displacement in the x-direction with respect to the sensor frames 20a and 20b.

Also, support springs 14a, 14b, 15a, and 15b for supporting the movement of the sensor mass bodies 10a and 10b and the sensor frames 20a and 20b in the y-direction are connected between anchors 50a and 50b and the sensor frames 20a and 20b in the y-direction. Between the two sensor frames 20a and 20b, at least one or more antiphase link mechanisms 20a and 20b are connected between the two sensor frames 20a and 20b in order to ensure perfect antiphase of the movement of the in the y-direction of the sensor frames 20a and 20b in the excitation mode. In FIG. 3, two antiphase link mechanisms 40a and 40b are disposed in a pair, but the number thereof is not limited thereto. However, from the viewpoint of eliminating the influence of the unbalance of the disposition of the antiphase link mechanism, it is preferable to use a plurality of antiphase link mechanisms, and in particular, it is necessary to arrange a plurality of antiphase link mechanisms to be line symmetrical in the left-rightward direction on the basis of the center.

On the other hand, in an embodiment of the present invention, in order to guide the first sensor mass body unit 10a and the second sensor mass body unit 10b to move in opposite directions on the basis of the x-axis at the time of the sensing mode, at least two horizontal seesaw link structures 30a, 32a, 34a, and 36a or 30b, 32b, 34b, and 36b may be used. At this time, the horizontal seesaw link structure may be configured to include seesaw bodies 30a and 30b, rotation links 32a, 32b, and 34a which connect both ends of the seesaw bodies 30a and 30b to the sensor mass body 10a and 10b, and pivot links 36a and 36b which connect the center of the seesaw bodies 30a and 30b to the fixing anchor 50a and 50b.

For example, when the first sensor mass body unit 10a moves in the positive x-axis direction (rightward direction), while the upper rotating links 32a and 32b also move in the positive x-axis direction, the seesaw bodies 30a and 30b pivots in a clockwise direction. At this time, since the lower ends of the seesaw bodies 30a and 30b move in the negative x-axis direction (leftward direction) due to the center pivot links 36a and 36b, the lower rotation link 34a and 34b move to the left side. Finally, the movement of the second sensor mass body unit 10b is guided in the negative x-axis direction (leftward direction) opposite to the direction of the first sensor mass body unit 10a.

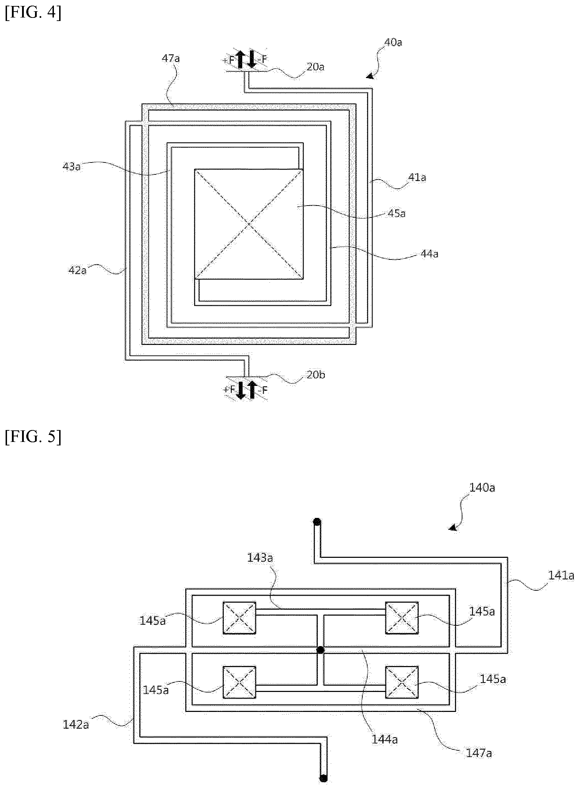

FIG. 4 is a diagram illustrating a first antiphase link mechanism 40a according to an embodiment of the present invention. The structure of the second antiphase link mechanism 40b is the same as that of the first antiphase link mechanism 40a except for being bilaterally symmetrical.

The antiphase link mechanism 40a includes two anchor connections 43a and 44a connected to a central anchor 45a having no movement to the gyro wafer, and two link arms 41a and 42a which are rotationally symmetrical with respect to each other by 180 degrees on the basis of the center of the antiphase link mechanism 40a and are connected to the two sensor frames 20a and 20b, respectively. Further, the antiphase link mechanism 40a includes a torsional stiffness support 47a which impart torsional stiffness to the antiphase link mechanism 40a, and is formed by closed curves passing through at least the intersection points between the two anchor connections 43a and 44a and the two link arms 41a and 42a. In addition to the torsional rigid support function, the torsional rigid support 47a includes a function of geometrically connecting a first structure including the first anchor connection 43a and the first link arm 41a, and a second structure including the second anchor connection 44a and the second link arm 42a.

In FIG. 4, if +F is added to the distal end of the first link arm 41a, due to the rotationally symmetric structure of 180 degree of the first antiphase link mechanism 40a, a reaction force of -F is exactly generated at the distal end of the second link arm 42a. Likewise, if -F is added to the distal end of the first link arm 41a, a reaction force of + F is exactly generated at the distal end of the second link arm 42a. Therefore, even though the excitation method using the excitation electrode does not completely excite the first sensor mass body unit 10a and the second sensor mass body unit 10b to the antiphase due to various design errors, because of the structural features of the antiphase link mechanism, the two sensor mass body units 10a and 10b can be excited to the completely antiphase.

FIG. 5 is a diagram illustrating an antiphase link mechanism 140a according to another embodiment of the present invention. In the present embodiment, in the first antiphase link mechanism 140a, the two link arms 141a and 142a or the torsional rigid support 147a have similar structures as compared with the antiphase link mechanism of FIG. 4. Instead, in this example, four central anchors 145a are used. Also, the method of connecting the torsional rigid support 147a and the four central anchors 145a has a substantially "I beam" shape. Specifically, the torsional rigid support 147a is connected by a horizontal link 144a crossing it, the center of the horizontal link 144a is connected to the I beam link 143a connected to the four central anchors 145a. Due to the structure connected to these four central anchors 145a in the I beam shape, the antiphase link mechanism 140a may have a relatively large stiffness with respect to the torsional external force.

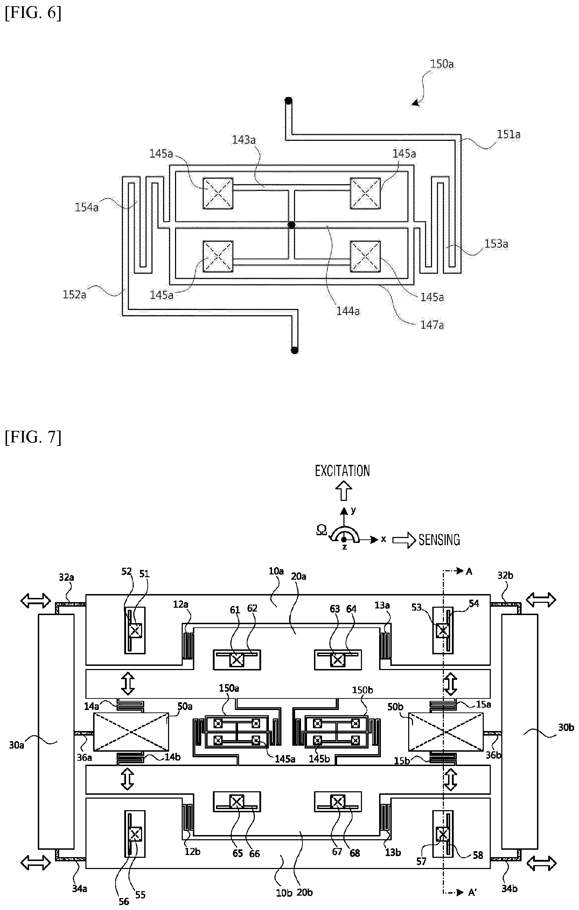

FIG. 6 is a diagram illustrating an antiphase link mechanism 150a according to another embodiment of the present invention. In this embodiment, as compared with FIG. 5, there is a difference only in that spring portions 153a and 154a are additionally formed in the two link arms 151a and 152b. The spring portions 153a and 154a formed on the link arm 151a and 152b enhance the stiffness of the two link arms 151a and 152b to a certain degree when an external force (+F or -F) acts on the end portions of the link arm 151a and 152b, and provide structural stability of the two link arms 151a and 152b. Therefore, it is possible to contribute to securing a more accurate antiphase as compared with the case with no spring portions 153a and 154a.

In the z-axis MEMS gyroscope as illustrated in FIG. 3, in the case of excitation of one degree of freedom in the y-axis direction, under the condition that the external rotational angular velocity $\Omega$ is given on the basis of the z-axis, vibration occurs in the x-direction by Coriolis force. Here, when ignoring the effect of the damping coefficient, the motion differential equation at the time of excitation can be expressed as Equation 1, and the motion differential equation at the time of sensing may be expressed as Equation 2.

[Equation 1]

$$(m_s + m_f)\ddot{y} + k_a y = F_d(t)$$

[Equation 2]

$$m_s \ddot{x} + k_b x = 2 m_s \dot{y} \Omega$$

Here, x is the displacement of the sensor mass bodies 10a and 10b in the x-direction, y is the displacement of the sensor mass bodies 10a and 10b in the y-direction, ms is the mass of the sensor mass bodies 10a and 10b, and mf is the mass of the sensor frames 20a and 20b. Further, ka is a stiffness of spring disposed in a vertical direction (sum of stiffness of the spring 14a or 14b and stiffness of the spring 15a or 15b in FIG. 3), and kb is stiffness of the spring disposed in the horizontal direction (sum of stiffness of the spring 12a or 12b and the stiffness of the spring 13a or 13b in FIG. 3). $\Omega$ is the external rotational angular velocity, and Fd(t) is the exciting force applied to the sensor mass bodies 10a and 10b and the sensor frames 20a and 20b.

Therefore, in the excitation mode, the sensor mass bodies 10a and 10b, and the sensor frames 20a and 20b are vibrated together in the y-direction. However, in the sensing mode, the sensor mass bodies 10a and 10b are vibrated in the x-direction with respect to the sensor frames 20a and 20b, and the sensor frames 20a and 20b does not substantially move in the x-direction.

FIG. 7 illustrates the structure of a z-axis gyroscope subjected to horizontal excitation and horizontal sensing on the x-y plane according to an embodiment of the invention. For illustrative purposes, a pair of link mechanisms 150a and 150b of antiphase in FIG. 6 are arranged.

Under the conditions in which the rotational angular velocity $\Omega$ in the z-axis direction is applied onto the gyro wafer, sensor mass bodies 10a and 10b and the sensor frames 20a and 20b are excited together in the y-direction by the excitation electrodes 62, 64, 66, and 68. The excitation electrodes 62, 64, 66, and 68 may be provided as a comb electrode, a plate electrode or other methods. The excitation electrodes 62, 64, 66, and 68 are attached and fixed to the side surfaces of the anchors 61, 63, 65, and 67 fixed to the wafer substrate, respectively. In the embodiment of FIG. 7, the case of using four excitation electrodes is taken as an example, but it goes without saying that the present invention is not limited to this case, and excitation electrodes smaller and larger may also be used.

In the above-described excitation mode, substantially no relative displacement of the sensor mass body 10a and 10b and the sensor frames 20a and 20b occurs in the y-direction, and vibration caused by the excitation is supported by the support springs 14a, 14b, 15a, and 15b arranged in the vertical direction (y-direction). At this time, the two sensor frames 20a and 20b are connected in the y-direction by the two antiphase link mechanisms 150a and 150b.

The two antiphase link mechanisms 150a and 150b are arranged symmetrically axisymmetrically with respect to each other in the x-axis direction. In the antiphase link mechanisms 150a and 150b, the force acting on the end portion of the link arm is converted into a reaction force of the completely antiphase at the end portion of the other link arm due to the rotationally symmetric structure of the antiphase link mechanisms 150a and 150b. Therefore, when the first sensor frame unit 20a moves downward, the lower link arms of the antiphase link mechanisms 150a and 150b pull the second sensor frame unit 20b upward. Conversely, when the first sensor frame unit 20a moves upward, the lower link arms of the antiphase link mechanisms 150a and 150b push the second sensor frame unit 20b downward. Thus, even if the excitation force applied to the upper first sensor mass body unit 10a and the first sensor frame unit 20a by the excitation electrodes 62, 64, 66, and 68, and the excitation force applied to the lower second sensor mass body unite 10b and the second sensor frame unit 20b do not have completely antiphase, and in fact, completely antiphase due to the antiphase link mechanisms 150a and 150b can be guaranteed in the vibration of the sensor mass bodies 10a and 10b and the sensor frames 20a and 20b.

On the other hand, when the rotation angular velocity $\Omega$ in the z-axis direction and the excitation in the y-axis direction simultaneously act, the sensor mass bodies 10a and 10b vibrates in the x-direction by the Coriolis force as illustrated in the right side of the expression 2. Here, the sensor mass bodies 10a and 10b are connected to the sensor frames 20a and 20b by support springs 12a, 13a, 12b, and 13b arranged in the horizontal direction, respectively. These support springs 12a, 13a, 12b, and 13b may also be provided as folding type MEMS beam springs which can also be linearly deformed. Therefore, in the sensing mode, the sensor frames 20a and 20b do not substantially move in the x-direction, and the sensor mass bodies 10a and 10b may move in the x-direction with respect to the sensor frames 20a and 20b.

On the other hand, since the completely antiphase of the excitation direction of the two sensor mass bodies 10a and 10b is guaranteed with respect to the y-axis by the antiphase link mechanisms 150a and 150b at the time of excitation, Coriolis force acting on the two sensor mass bodies 10a and 10b is also completely opposite. Therefore, in the sensing mode, if the first sensor mass body unit 10a moves in the negative x-axis direction (leftward direction), the second sensor mass body unit 10b moves in the positive x-axis direction (rightward direction). In addition, if the first sensor mass body unit 10a moves in the positive x-axis direction (rightward direction), the second sensor mass body unit 10b moves in the negative x-axis direction (leftward direction). The reciprocal movement of the sensor mass bodies 10a and 10b in the sensing mode is naturally guided by the horizontal seesaw link structures 30a, 32a, 34a, and 36a or 30b, 32b, 34b, and 36b. The horizontal seesaw link structures include seesaw main bodies 30a and 30b, rotation links 32a, 32b, 34a, and 34b which connect both ends of the seesaw main bodies 30a and 30b to the sensor mass bodies 10a and 10b, and pivot links 36a and 36b which connect the center of the seesaw bodies 30a and 30b to the fixing anchors 50a and 50b. Therefore, if the first sensor mass body unit 10a moves in the x-axis direction (rightward direction), while the upper rotation links 32a and 3b also move in the x-axis direction, the upper seesaw bodies 30a and 30b pivot in the clockwise direction. At this time, the lower ends of the seesaw bodies 30a and 30b move in the negative x-axis direction (leftward direction) by the central pivot links 36a and 36b, and thus, the lower rotation links 34a and 34b move toward the left side. Finally, the movement of the second sensor mass body unit 10b is guided in the negative x-axis direction (leftward direction) which is a direction opposite to that of the first sensor mass body unit 10a.

The movement in the Coriolis force direction (x-direction) of the sensor mass body 10a and 10b may be determined by the interval between each of the sensor mass body 10a and 10b and each of the sensing electrodes 52, 54, 56, and 58 or may be detected by a change in electrostatic capacitance due to a change in area. These sensing electrodes 52, 54, 56, and 58 can also be provided as comb electrodes or flat plate electrodes, and may be attached to the side surfaces of the anchors 51, 53, 55, and 57 fixed to the wafer substrate, respectively. In the embodiment of FIG. 7, the case of using four sensing electrodes is taken as an example, but the present invention is not limited thereto, and it goes without saying that a smaller number or more sensing electrodes may be used.

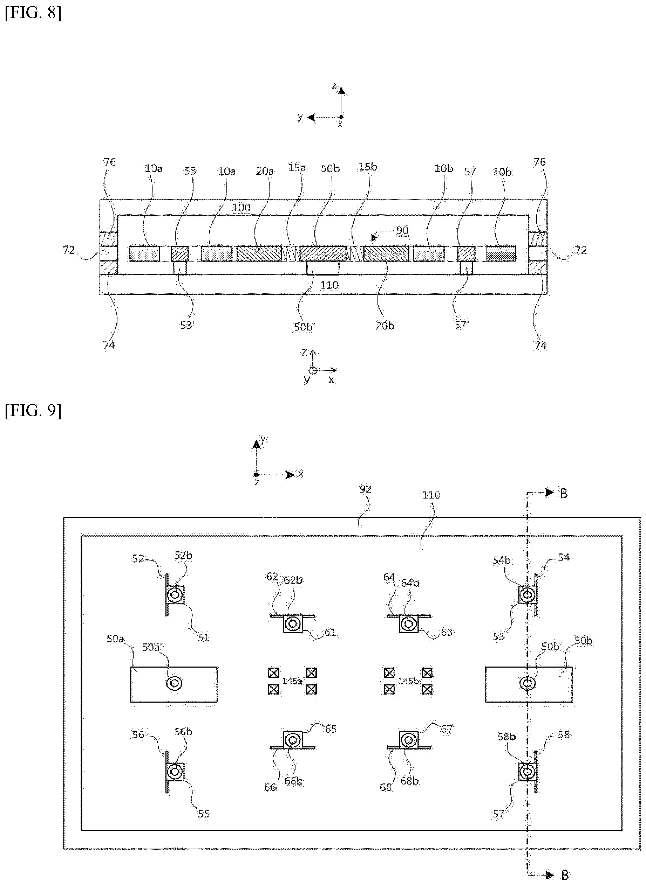

FIG. 8 is a diagram schematically illustrating a cross-section taken along the line A-A' of the z-axis MEMS gyroscope of FIG. 7. In FIG. 8, the z-axis MEMS gyroscope of FIG. 7 is located in an internal space between the bottom wafer 110 surrounded by the sealing walls 72, 74, and 76 of the gyro wafer 100. The support springs 15a and 15b connect the anchor 50b and the sensor frames 20a and 20b, and serve as a support when the sensor frames 20a and 20b is excited in the y-axis direction.

Anchors 53 and 57 for fixing the sensing electrodes are located inside the sensor mass bodies 10a and 10b, and below the sensor frames 20a and 20b and the sensor mass bodies 10a and 10b, i.e., below the gyro wafer 90, bottom wafers 110 are spaced apart at regular intervals. At this time, the anchors 50b, 53, and 57 extend to reach from the gyro wafer 90 to the bottom wafer 110 (50b', 53', and 57'). Therefore, even when the sensor frames 20a and 20b or the sensor mass body 10a and 10b in the gyro wafer 90 vibrate, the anchors 50b, 53, and 57 are fixed without being moved.

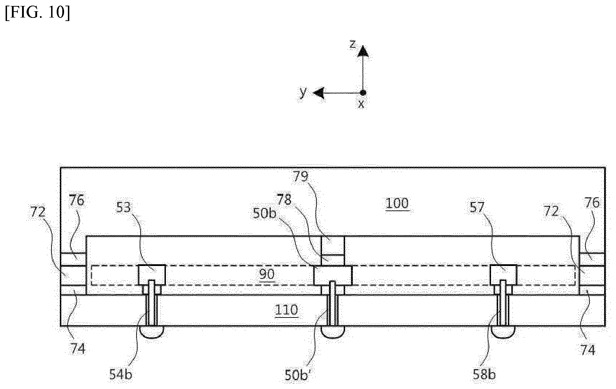

FIG. 9 is a plan view illustrating several anchors 50a, 50b, 51, 53, 55, 57, 61, 63, 65, 67, 145a, and 145b, silicon penetration electrodes 50a', 50b', 52b, 54b, 56b, 58b, 62a, 64b, 66b, and 68b of the bottom wafer 110, and the sealing wall 92 with respect to the z-axis gyroscope according to the embodiment of FIG. 7. Further, FIG. 10 is a diagram schematically illustrating a cross-section taken along the line B-B' from the x-y axis gyroscope of FIG. 9.

In FIG. 10, the sealing walls 72, 74, and 76 are one wall that blocks the inside and the outside in order to protect the z-axis gyroscope structure. The silicon penetration electrode 50b' of the bottom wafer 110 means wiring connection for supplying power to the sensor frames 20a and 20b and the sensor mass body 10a and 10b, and the silicon penetration electrodes 54b and 58b of the bottom wafer are wirings for outputting signals detected by the sensor sensing electrodes 54 and 58 to the outside. Pillars 78 and 79 are provided between the cap wafer 100 and the gyro wafer 90 so that excitation vibration energy of the gyro wafer 90 can be separately dispersed into the bottom wafer 110 and the cap wafer 100, respectively.

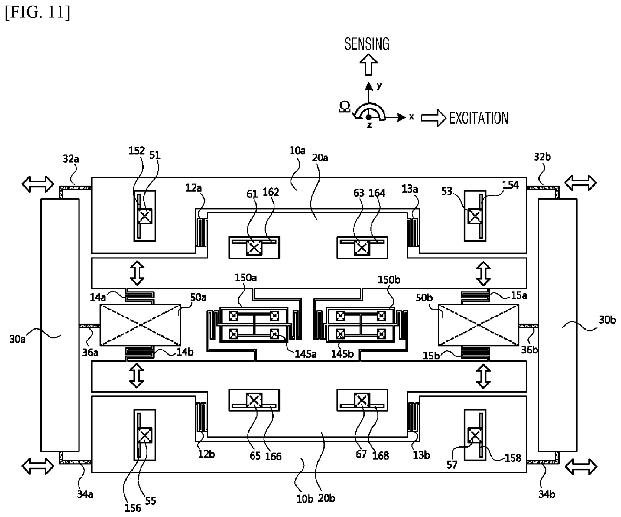

The z-axis MEMS gyroscope which is excited in the y-axis direction and performs sensing in the x-axis direction in connection with the embodiment described in FIG. 7 has been described. FIG. 11 illustrates a z-axis MEMS gyroscope that is excited to the x-axis direction and performs sensing in the y-axis direction as another example. In the z-axis gyroscope, since the external rotation is applied to the z-axis, and the excitation direction and the sensing direction are performed in the gyro wafer plane, the excitation direction and the sensing direction can be conversely operated in the same structure as in FIG. 7.

Referring to FIG. 11, the overall structure of the z-axis gyroscope is similar to that of FIG. 7, but the excitation direction and the sensing direction are opposite to each other. Therefore, the excitation electrodes 62, 64, 66, and 68 and the sensing electrodes 52, 54, 56, 58 of FIG. 7 are used by being replaced with the sensing electrodes 162, 164, 166, and 168, and the excitation electrodes 152, 154, 156, and 158, respectively.

Specifically, the sensors masses 10a and 10b are excited in the x-axis direction by the excitation electrodes 152, 154, 156, and 158. At this time, the first sensor mass body unit 10a and the second sensor mass body unit 10b are excited in the mutually opposite directions. Such an excitation in the opposite direction can be guided by the horizontal seesaw link structures 30a, 32a, 34a, and 36a or 30b, 32b, 34b, and 36b.

For example, if the first sensor mass body unit 10a is excited in the positive x-axis direction (rightward direction), while the upper rotating link 32a and 32b also move in the x-axis direction, the seesaw main bodies 30a and 30b pivot in a clockwise direction. At this time, since the lower ends of the seesaw bodies 30a and 30b move in the negative x-axis direction (leftward direction) due to the center pivot links 36a and 36b, the lower rotation link 34a and 34b move to the left side. Finally, the motion of the second sensor mass body unit 10b excited in the negative x-axis direction is guided in the negative x-axis direction (leftward direction) which is the direction opposite to that of the first sensor mass body unit 10a. Of course, when the first sensor mass body unit 10a is excited in the negative x-axis direction (leftward direction), the motion of the second sensor mass body unit 10b will be guided in the x-axis direction (rightward direction).

Excitation of the sensor mass bodies 10a and 10b in the x-direction of these causes the motion in the y-direction by the Coriolis force, under the external rotational angular velocity $\Omega$. Here, since the excitation directions of the respective sensor mass bodies 10a and 10b are opposite to each other, the Coriolis force acting on the respective sensor mass bodies 10a and 10b also becomes opposite to each other. That is, when the first sensor mass body unit 10a moves in the positive y-direction, the second sensor mass body unit 10b moves in the negative y-direction, and when the first sensor mass body unit 10a moves in the negative y-direction, the second sensor mass body unit 10b moves in the positive y-direction. At this time, the sensor mass bodies 10a and 10b move integrally with the sensor frames 20a and 20b in the same sensing direction (positive y-direction or negative y-direction), and the movement thereof is detected by the sensing electrodes, 164, 166, and 168.

The antiphase link mechanisms 150a and 150b provide reaction force of the perfectly opposite phase with respect to the motion in the sensing direction of the sensor mass bodies 10a and 10b and the sensor frame 20a and 20b at the end portion of the link arm. Therefore, when the first sensor frame unit 20a moves downward, the lower link arm of the antiphase link mechanisms 150a and 150b pulls the second sensor frame unit 20b upward. Conversely, when the first sensor frame unit 20a moves upward, the lower link arm of the antiphase link mechanisms 150a and 150b push the second sensor frame unit 20b downward. Therefore, perfect antiphase can be guaranteed to the motion in the sensing direction of the sensor mass body 10a and 10b and the sensor frames 20a and 20b.

Although the embodiments of the present invention have been described with reference to the accompanying drawings, those skilled in the art to which this invention pertains will appreciate that the invention can be implemented in other concrete form without changing the technical spirit or essential characteristics. Accordingly, it is understood that the embodiments described above are illustrative rather than limited in all aspects.

**Claims**

1. A MEMS-based gyroscope comprising:

   a sensor frame disposed parallel to a bottom wafer substrate;
   a sensor mass body which relatively moves to the sensor frame, and is excited at one degree of freedom in an excitation mode; and
   at least one sensing electrode which senses displacement of the sensor mass body at the one degree of freedom in a sensing mode by Coriolis force, when an external angular velocity is input to the sensor mass body,
   wherein the sensor mass body includes two mass units, the two mass units are arranged in line symmetry with each other, and the antiphase motion of the two mass units is maintained by an antiphase link mechanism directly or indirectly connected between the two mass units.

2. The MEMS-based gyroscope of claim 1, further comprising:

   a first spring which connects the sensor mass body and the sensor frame in one direction and supports the motion of the sensor mass body in the excitation direction; and
   a second spring which connects the sensor mass body and the sensor frame in a direction perpendicular to the one direction, and supports motion of the sensor mass body in the sensing direction.

3. The MEMS-based gyroscope of claim 2, wherein the first spring and the second spring each have a linearly deformable beam shape.

4. The MEMS-based gyroscope of claim 1, wherein the antiphase link mechanism includes two link elements arranged in line symmetry toward the excitation direction of the sensor mass body.

5. The MEMS-based gyroscope of claim 4, wherein each of the two link elements is fixed by an anchor having no movement and is connected to the two sensor mass body units by two link arms.

6. The MEMS-based gyroscope of claim 5, wherein the two link arms are rotationally symmetrical with respect to each other by 180 degrees on the basis of the center of the antiphase link mechanism.

7. The MEMS-based gyroscope of claim 1, wherein the two sensor mass body units are excited at one degree of freedom by being horizontally vibrated with respect to the bottom wafer substrate by an electrostatic force generated by at least one or more horizontal electrodes arranged in a direction perpendicular to the bottom wafer substrate, and the antiphase motion of the two sensor mass body units is guarantee by the antiphase link mechanism.

8. The MEMS-based gyroscope of claim 7, wherein the sensor mass body vibrates in the sensing mode of one degree of freedom by the Coriolis force induced by an external angular velocity about an axis perpendicular to the bottom wafer substrate.

9. The MEMS-based gyroscope of claim 8, wherein in the sensing mode of one degree of freedom, the two sensor mass body units exhibit a seesaw motion on a plane having antiphase to each other.

10. The MEMS-based gyroscope of claim 9, further comprising:

two horizontal seesaw link mechanisms which support a twisting motion on a plane to exhibit the seesaw motion on the plane.

11. The MEMS-based gyroscope of claim 1, wherein the sensor frame includes two sensor frame units coupled respectively with the two sensor mass body units, the two sensor frame units being capable of moving in the excitation direction together with the two sensor mass body units in the excitation mode, but in the sensing mode, the two sensor frame units having substantially no motion.

12. The MEMS-based gyroscope of claim 11, wherein the antiphase link mechanism interconnects the two sensor frame units to maintain the antiphase motion of the two sensor mass body units.

[FIG. 1]

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

## INTERNATIONAL SEARCH REPORT

| International application No. |
| --- |
| **PCT/KR2016/004861** |

| A. CLASSIFICATION OF SUBJECT MATTER |
| --- |
| *G01C 19/5712(2012.01)i, G01C 19/574(2012.01)i, B81B 7/02(2006.01)i* |
| According to International Patent Classification (IPC) or to both national classification and IPC |

| B. FIELDS SEARCHED |
| --- |
| Minimum documentation searched (classification system followed by classification symbols) |
| G01C 19/5712; G01C 19/5621; G01P 15/125; H01L 29/84; B81B 7/00; G01C 19/00; G01C 19/56; G01C 19/574; B81B 7/02 |
| Documentation searched other than minimum documentation to the extent that such documents are included in the fields searched<br>Korean Utility models and applications for Utility models: IPC as above<br>Japanese Utility models and applications for Utility models: IPC as above |
| Electronic data base consulted during the international search (name of data base and, where practicable, search terms used)<br>eKOMPASS (KIPO internal) & Keywords: MEMS gyroscopes, symmetry, Z shaft, antiphase, sensor mass compaction, sensing electrode and axial symmetry |

| C. DOCUMENTS CONSIDERED TO BE RELEVANT | | |
| --- | --- | --- |
| Category* | Citation of document, with indication, where appropriate, of the relevant passages | Relevant to claim No. |
| A | KR 10-2013-0084950 A (KOREA ADVANCED INSTITUTE OF SCIENCE AND TECHNOLOGY et al.) 26 July 2013<br>See abstract, claims 1-5 and figures 8-14. | 1-12 |
| A | JP 2013-250125 A (ALPS ELECTRIC CO., LTD.) 12 December 2013<br>See abstract, claims 1, 8 and figures 1-10, 17. | 1-12 |
| A | KR 10-2001-0045331 A (SAMSUNG ELECTRONICS CO., LTD.) 05 June 2001<br>See abstract, claim 1 and figures 1, 2. | 1-12 |
| A | KR 10-2004-0035946 A (SAMSUNG ELECTRO-MECHANICS CO., LTD.) 30 April 2004<br>See abstract, claim 1 and figure 3. | 1-12 |
| A | KR 10-2010-0024516 A (NORTHROP GRUMMAN LITEF GMBH.) 05 March 2010<br>See abstract, claim 1 and figure 5. | 1-12 |

| ☐ Further documents are listed in the continuation of Box C. | ☒ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 26 AUGUST 2016 (26.08.2016) | **26 AUGUST 2016 (26.08.2016)** |
| Name and mailing address of the ISA/KR<br>Korean Intellectual Property Office<br>Government Complex-Daejeon, 189 Seonsa-ro, Daejeon 302-701, Republic of Korea<br>Facsimile No. 82-42-472-7140 | Authorized officer<br><br>Telephone No. |

Form PCT/ISA/210 (second sheet) (January 2015)

INTERNATIONAL SEARCH REPORT
Information on patent family members

International application No.

**PCT/KR2016/004861**

| Patent document cited in search report | Publication date | Patent family member | Publication date |
|---|---|---|---|
| KR 10-2013-0084950 A | 26/07/2013 | KR 10-1371149 B1 | 06/03/2014 |
| JP 2013-250125 A | 12/12/2013 | CN 103454450 A<br>CN 103454450 B<br>JP 5898571 B2 | 18/12/2013<br>08/04/2015<br>06/04/2016 |
| KR 10-2001-0045331 A | 05/06/2001 | EP 1098170 A2<br>EP 1098170 A3<br>EP 1098170 B1<br>JP 2001-174266 A<br>US 6467348 B1 | 09/05/2001<br>20/11/2002<br>29/11/2006<br>29/06/2001<br>22/10/2002 |
| KR 10-2004-0035946 A | 30/04/2004 | CN 1497240 A<br>CN 1497240 C<br>EP 1408302 A2<br>EP 1408302 A3<br>EP 1408302 B1<br>JP 2004-132988 A<br>TW 200416394 A<br>TW I230781 B<br>US 2004-0069062 A1<br>US 6860150 B2 | 19/05/2004<br>22/03/2006<br>14/04/2004<br>12/10/2005<br>14/11/2007<br>30/04/2004<br>01/09/2004<br>11/04/2005<br>15/04/2004<br>01/03/2005 |
| KR 10-2010-0024516 A | 05/03/2010 | AU 2008-271664 A1<br>AU 2008-271664 B2<br>CA 2701384 A1<br>CA 2701384 C<br>CN 101688776 A<br>CN 101688776 B<br>EP 2162702 A1<br>EP 2162702 B1<br>JP 2010-531446 A<br>JP 5138772 B2<br>US 2010-0116050 A1<br>US 8342023 B2<br>WO 2009-003541 A1 | 08/01/2009<br>16/02/2012<br>08/01/2009<br>16/09/2014<br>31/03/2010<br>21/09/2011<br>17/03/2010<br>21/03/2012<br>24/09/2010<br>06/02/2013<br>13/05/2010<br>01/01/2013<br>08/01/2009 |

Form PCT/ISA/210 (patent family annex) (January 2015)